# EUROPEAN PATENT APPLICATION

(11) **EP 2 660 611 A1**
(43) Date of publication of application: **06.11.2013**
(21) Application number: 12166233.2
(22) Date of filing: 30.04.2012
(51) Int. Cl.: G01R 15/20

(54) **Electrical current transducer module**

(71) Applicant: LEM Intellectual Property SA, 1700 Fribourg (CH)
(72) Inventor: Turpin, Pierre, 74800 La Roche sur Foron (FR); Sage, Philippe, 01200 Chatillon En Michaille (FR); Cattaneo, Frédéric, 74560 Monnetier-Mornex (FR)
(74) Representative: reuteler & cie SA

(57) **Abstract**

Electric current transducer module comprising a magnetic circuit with a magnetic core (2) and an air gap (20), the magnetic core having a central passage (18) configured to receive a primary conductor (14) carrying a primary current to be measured. The electric current transducer module further comprises a signal processing circuit (8) including a circuit board (17) and contact terminals (32) for connection to external circuitry, and a magnetic field detector (4) arranged at least partially in the air gap (20) of the magnetic circuit. The electric current transducer module further comprises a magnetic core mounting support (6) comprising a molded support (15) and a grounding and fixing mechanism (12) configured to hold and rigidly fix the magnetic core (2) to the molded base to form a magnetic circuit unit (3). The magnetic circuit unit (3) is configured to be fixedly assembled to the printed circuit board.

## Description

The present invention relates to an electric current transducer module comprising a magnetic circuit and a magnetic field detector in an air-gap of the magnetic circuit, for measuring an electrical current flowing in a primary conductor inserted through a central passage of the magnetic circuit.

Electrical current transducer modules for current sensing applications typically comprise a magnetic core made of a high permeability magnetic material, surrounding a central aperture through which passes a primary conductor carrying the current to be measured. The magnetic core may typically have a generally rectangular or circular shape and be provided with an air-gap in which a magnetic field detector, such as a Hall effect sensor in the form of an ASIC, is positioned. The magnetic flux generated by the electrical current flowing in the primary conductor is concentrated by the magnetic core and passes through the air-gap. The magnetic field in the air-gap is representative of the primary current. In current transducers of the open-loop type, the magnetic field sensor in the air-gap generates an image of the current to be measured that represents the measurement signal. In current sensors of the closed-loop type the magnetic field sensor is connected in a feed-back loop to a coil that is typically wound around a portion of the magnetic core in order to generate a compensation current that tends to cancel the magnetic field generated by the primary conductor. The compensation current thus represents an image of the current to be measured. A difference in potential between the magnetic core and the measurement signal processing circuit may adversely influence the measurement signal and it is therefore common to connect the magnetic core electrically to a reference voltage, namely ground, of the signal processing circuit.

In certain conventional current transducer modules, the magnetic core is directly mounted on a circuit board, for example with an adhesive, a mechanical fixing or the like. Such a magnetic core is in most cases connected to ground as a reference voltage for example via a conductive member which is positioned against the magnetic core.

When a magnetic circuit with an air gap is used, the width of the air gap has an influence on the magnetic field strength in the air gap. This field strength is measured by the magnetic field detector positioned in the air gap. Therefore the width of the air gap should be as constant as possible even over a high temperature range.

Mounting of a magnetic core on a circuit board poses different problems. Mechanical stresses due to vibration and shocks, and thermal stresses resulting from different thermal expansion coefficients of the magnetic core and the circuit board may lead to cracking or rupture of electrical or mechanical contacts, or to variations in the size of the air-gap.

In certain conventional known embodiments, the magnetic core is not fixed to a circuit board but in a cavity of a molded housing. Relative movement between the magnetic core, the housing, and the circuit board on which the magnetic field sensor is positioned due to temperature changes or vibration or shocks may however adversely effect on the measurement accuracy.

In certain applications, space is limited; however open-loop current sensors generally increase in size as a function of the maximum rated current to be measured in order to avoid saturation of the magnetic core.

An object of the invention is to provide an electrical current transducer module that is accurate, economical, and compact.

It is advantageous to provide an electrical current transducer module that is easy to produce and assemble.

It is advantageous to provide an electrical current transducer module that is robust and stable.

It is advantageous to provide an electrical current transducer module that is compact for use in limited space applications, yet can measure large currents.

It is advantageous to provide an electrical current transducer module that is configured for receiving a primary conductor therethrough that is compact yet allows a certain freedom of movement to the primary conductor.

It is advantageous to provide an electrical current transducer module that is flexible in configuration.

Objects of the invention have been achieved by providing a current transducer according to claim 1.

Disclosed herein is an electric current transducer module comprising a magnetic circuit comprising a magnetic core, an air gap, and a central passage configured to receive a primary conductor carrying a primary current to be measured through the central passage, a signal processing circuit including a circuit board and electrical terminals for connection to external circuitry, and a magnetic field detector arranged at least partially in the air gap of the magnetic circuit. The transducer further comprises a magnetic core mounting support comprising a molded support and a grounding and fixing mechanism configured to hold and rigidly fix the magnetic core to the molded support

In an advantageous embodiment, the central passage of the magnetic core comprises an oval shape and the molded support comprises a primary conductor passage substantially congruent with the central passage. The molded support thus forms a mechanically closed circuit around the central passage that offers rigidity and stability to the magnetic core, in particular to stabilize the width of the air gap. The oval shape of the passage provides a compact magnetic circuit arrangement that reduces pinch zones leading to magnetic saturation yet allows a freedom of positioning in the direction of the major axis of the oval passage for the primary cable to bend away as it exits the transducer. The magnetic field detector is fixed to the molded support.

The molded support may advantageously be made as a single part of injected plastic. In an advantageous embodiment, the molded support comprises a base and at least one positioning post protruding from the base, said positioning post engaging in a complementary positioning cavity formed in the magnetic core configured for positioning the magnetic core on the magnetic core mounting support.

The molded support may advantageously comprise a plurality of positioning posts and the magnetic core a corresponding plurality of complementary positioning cavities, whereby at least two positioning posts and two complementary positioning cavities are arranged on opposite sides of the air gap. The positioning posts and the complementary positioning cavities preferably engage in a force-fit manner.

The molded support may advantageously further comprise a magnetic field sensor guide member configured to position and hold the magnetic field detector within the air gap.

The grounding and fixing mechanism comprises at least one fixing pin fixed rigidly to the molded support and configured to be mechanically fixed at one end to the magnetic core and at another end to the circuit board. At least one of the fixing pins may advantageously also form a conductive grounding member electrically connecting the magnetic core to an electrical ground contact of the signal processing circuit. The fixing pins may advantageously be crimped over the magnetic core. The fixing pins are preferably mounted to the molded support by a force-fit insertion through through-holes in the support or by overmolding of the support and may advantageously extend through the positioning posts. The fixing pins advantageously comprise ends for mechanical and/or solder connection to the circuit board. The assembly by force fit or overmolding of the crimpable fixing pins to the molded support, the pins also serving as a mechanical and electrical connection to the circuit board, provides an economical yet compact and robust arrangement.

Further objects and advantageous features of the invention will be apparent from the claims, from the detailed description, and annexed drawings, in which:
Fig. 1 is a perspective view of an electrical current transducer module according to an embodiment of the invention;
Fig. 2 is a perspective view of the embodiment according to figure 1, with a housing removed;
Fig. 3 is a top view of the embodiment of figure 1;
Fig. 4 is a view in cross section along line C - C of figure 3;
Fig. 5 is a view in cross section along line A - A of figure 3;
Fig. 6 is a view in cross section along line B - B of figure 3;
Fig. 7 is a perspective view of an embodiment of a magnetic core used in an electrical current transducer module according to the invention;
Fig. 8 is a perspective view of the magnetic core of figure 7 mounted on an embodiment of a mounting support used in an electrical current transducer module according to the invention;
Fig. 9 is another perspective view of the magnetic core and mounting support of figure 8; and
Fig. 10 is an enlarged view in cross section along line C - C of figure 3.

Referring to the figures, an exemplary embodiment of an electric current transducer module 1 comprises a housing 10, a signal processing circuit 8, and a magnetic circuit unit 3. The signal processing circuit 8 comprises a circuit board 17.

The magnetic circuit unit 3 comprises a magnetic circuit comprising a magnetic core 2 made of a high magnetically permeable material and an air gap 20, a magnetic core mounting support 6 on which the magnetic core 2 is mounted and a magnetic field detector 4.

The magnetic circuit unit 3 comprises a central passage 18 through which a primary conductor 14 may be guided. The magnetic core 2 is made of high magnetically permeable laminations 22. In a variant the magnetic core 2 may be made of ferrite or another high magnetically permeable material configured to conduct and concentrate the magnetic field generated by the electrical current flowing in the primary conductor. The magnetic field detector 4 may be a Hall effect sensor 24 in the form of an ASIC, as is per se well known in the art.

The magnetic core mounting support 6 comprises a molded support 15 configured to position and hold the magnetic core 2, and a grounding and fixing mechanism 12 configured to secure the magnetic core 2 on the magnetic core mounting support 6 and further to electrically connect the magnetic core to ground via a connection on the circuit board 17.

The molded support 15 comprises a base 16, positioning portions 26 configured to engage and position the magnetic core, magnetic field sensor guide members 28 configured to position the magnetic field sensor, a primary conductor passage 29 aligned and conforming with the central passage 18 of the magnetic core to allow the primary conductor to extend therethrough, and one or more locking portions 56 with engaging shoulders for fixing the magnetic core mounting support 6 to the circuit board 17 and/or the housing 10. The molded support 15 is advantageously integrally formed as a single component comprising the base 16, the positioning posts 26, the magnetic field sensor guide members 28 and the locking portions 56, for example by injection molding of a polymer material. The positioning portions may advantageously be in the form of posts, for instance cylindrically shaped posts as shown in the embodiment illustrated in the figures, that protrude from the base 16 and are configured to be received in complementary positioning cavities 40 in the magnetic core 2.

The grounding and fixing mechanism comprises at least one conductive grounding member 38 which is in physical contact with the magnetic core 2 and configured to be electrically connected to an electrical grounding conductor of the signal processing circuit 8.

In the embodiment illustrated, the housing 10 comprises a cover portion 34 and base portion 36 configured to be assembled and fixed together to house the signal processing circuit and magnetic circuit therein. The circuit board 17 comprises conductive tracks, electrical terminals 32 (e.g. pin terminals) for connecting the signal processing circuit 8 to external circuitry, and a primary conductor passage 33 aligned and conforming with the central passage 18 of the magnetic core to allow the primary conductor to extend therethrough.

The cover portion 34 of the housing 10 advantageously comprises a passage 49 configured to guide a primary conductor through the central passage 18 of the magnetic core and to allow the conductor to be bent out of the axial direction A as it exits the top side of the cover portion 34. This provides more flexibility in installation of the current transducer in cramped conditions.

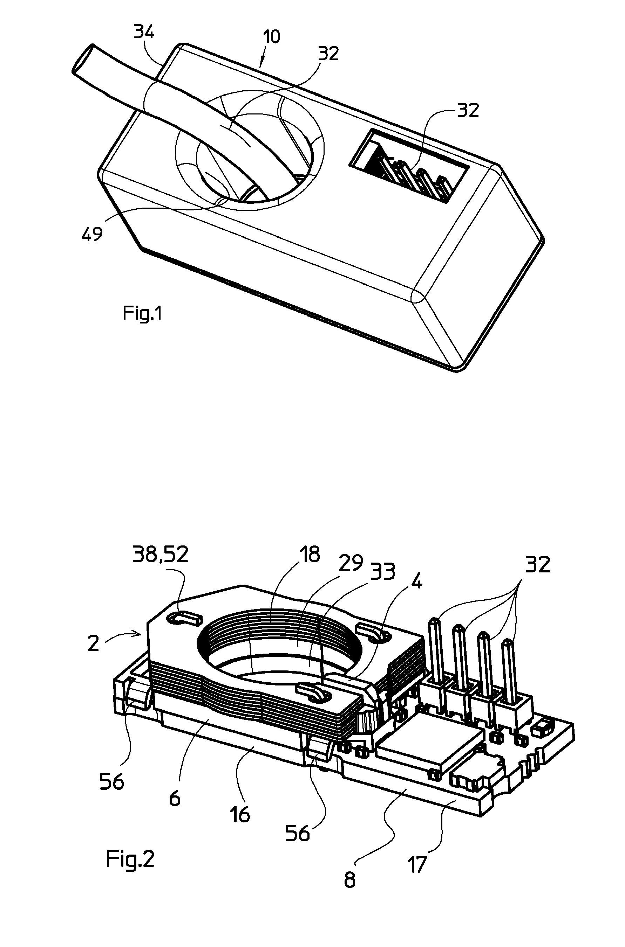

The magnetic core 2, the magnetic field detector 4 and the magnetic core mounting support 6 are mounted on a circuit board 17 of the signal processing circuit 8, as best seen in figure 2. The connecting terminals 32 of the circuit board 17 serve for grounding of the circuit board 8 and the magnetic core 2 and also for connecting the electric current transducer module 1 to external circuitry (not shown) for transmission of the measurement signals and for power supply.

The magnetic core 2 comprises the central passage 18, which may advantageously have a generally oval shape, to receive a primary conductor 14 extending therethrough. The central passage 18 may have various other shapes than the illustrated shape, such as circular or rectangular, depending on the application and the associated space constraints. The oval shape is however of advantage when the primary conductor 14 is a flexible cable and needs to bent out of the axial direction A as it exits the transducer, the axial direction being defined by a direction orthogonal to the circuit board 17.

The magnetic circuit comprises the air gap 20 which is configured to at least partially receive a magnetic field detector 4. The magnetic field detector 4 may for example be a Hall sensor in the form of an ASIC. The primary conductor 14 creates an electromagnetic field that is concentrated in the magnetic core 2. In the air gap 20, the magnetic flux density is measured by the magnetic field detector 4. The magnetic flux density in the air gap 20 is proportional to the current in the primary conductor 14 and can therefore be determined *inter alia* via the magnetic field detector 4. In order to provide a reliable and accurate electric current transducer module 1, it is advantageous to maintain a stable width of the air gap 20 over the range of temperatures and vibrations or mechanical shocks for which the transducer is specified to handle for the application concerned. If the width of the air gap 20 changes, the magnetic flux density in the air gap 20 also changes and the measurement accuracy is reduced.

The magnetic core 2 may be made of ferrite or of stacked sheets of high magnetically permeable material 22, for instance soft iron sheets, as is per se well known in the art.

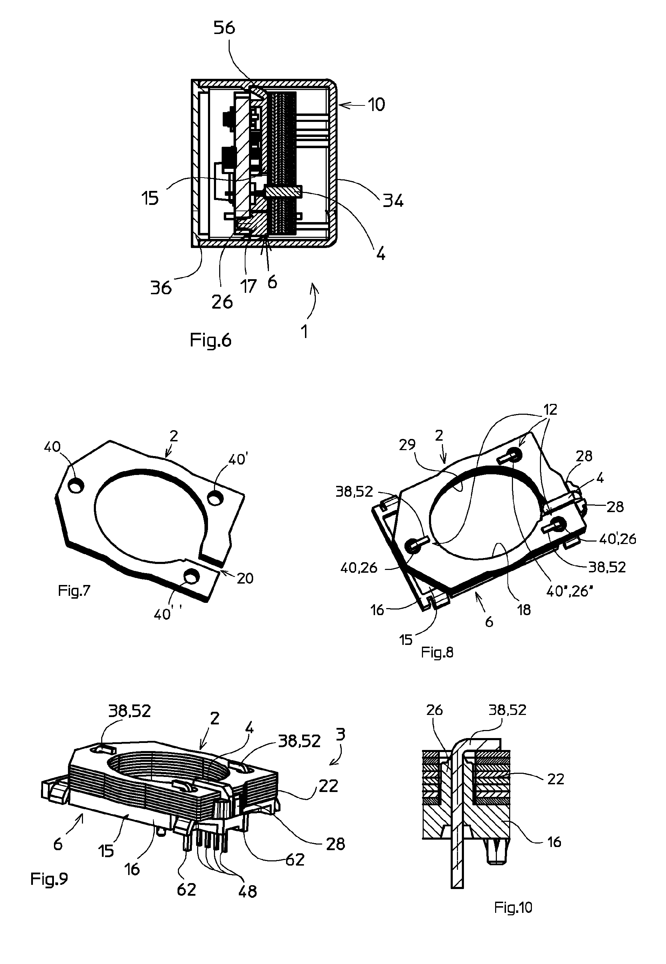

Referring to figures 8 and 9 the magnetic core mounting support 6 is shown with the magnetic core 2 and the magnetic field detector 4 mounted on it, forming together the magnetic circuit unit 3. Advantageously, the magnetic field detector 4 is positioned by the molded support 15 accurately and stably in the air gap 20 of the magnetic circuit.

The molded support 15 may advantageously be produced by injection molding a polymer material. The molded support 15 comprises a base 16 and a positioning post or portion 26 which is configured to engage with the complementary positioning cavity or portion 40 formed in the magnetic core 2. The positioning post 26 and the complementary positioning cavity 40 may advantageously engage in a tight or force fit manner to hold and fix the magnetic core 2 onto the molded support 15 of the magnetic core mounting support 6. It is also possible that the positioning post 26 and the complementary positioning cavity 40 engage in another manner such as a form fit or by using an adhesive.

The molded support 15 comprises the primary conductor passage 29 which is at least approximately congruent with the central passage 18 of the magnetic core 2. The base 16 may be integrally formed with the positioning posts 26 and the magnetic field sensor guide member 28 during the injection molding process.

The molded support 15 may advantageously further comprise a magnetic field sensor guide member 28 configured to guide and hold the magnetic field detector 4 in position when it is directly mounted on the molded support 15 or when the magnetic field detector 4 is mounted on the circuit board 17.

In a variant, the positioning post 26 and the complementary positioning cavity 40 may have other shapes and engaging surfaces. The positioning post 26 may be a rigid frame integrally formed on the base 16 of the molded support 15, which engages with the side or top surfaces of the magnetic core 2. Advantageously, the molded support 15, the positioning post 26 and the complementary positioning cavity 40 ensure that the magnetic core 2 is rigidly connected to the magnetic core mounting support 6, so that variations in the width of the air gap 20 are minimized even when the temperature changes or when vibrations occur. In order to minimize variations in the width of the air gap 20 it is of advantage to provide positioning posts 26 and complementary positioning cavities 40 on either side of the air gap 20 when the magnetic core 2 is mounted as best seen in figures 2 and 7. This way the movement of the magnetic core 2 in the area of the air gap 20 is blocked.

As illustrated in figures 1 and 4 to10 the conductive grounding member 38 of the grounding and fixing mechanism 12 may be a fixing pin 52 which can be crimped onto the magnetic core 2. Other solutions for grounding metal as known by a person skilled in the art also fall under the scope of the invention such as for example the use of a wire or a metal plate, which is in physical contact with the magnetic core 2. In an advantageous variant of the invention the conductive grounding member 38 is directly mounted and pre-assembled to the molded support 15, for example during an injection-molding process, or force fitted into a hole formed in the molded support 15, said hole being intended to receive the grounding member 38.

The conductive grounding member 38 may further have a securing function, by crimping the fixing pin 52 onto the magnetic core 2, once the magnetic core 2 is fitted onto the magnetic core mounting support 6 as illustrated in figures 1 and 4 to 9.

The magnetic circuit unit 3 may be mounted on to the circuit board 17, as shown for example in figure 2, and fixed thereto by means of the fixing and/or grounding pins 38, 52 that are on the one hand fixed to the molded support 15 and crimped over the magnetic core 2, and on the other hand soldered or force fit coupled to the circuit board 17. The circuit board 17 comprises a primary conductor passage 33 which is congruent with the primary conductor passage 29 of the molded support 15 and the central passage 18 of the magnetic core 2.

The molded support 15 of the magnetic circuit unit 3 may further comprise locking shoulders 56 configured to engage a complementary locking shoulders on the housing 10.

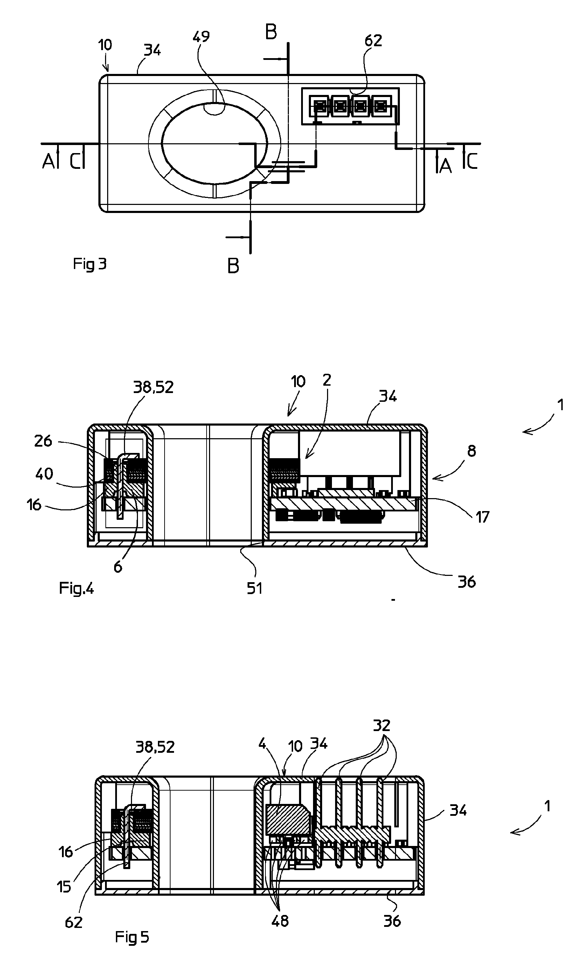

In the embodiment illustrated, there are three complementary positioning cavities 40 arranged in the magnetic core 2 and corresponding positioning posts 26 in the molded support 15, whereby two are positioned either side in close proximity to the air gap 20. In a variant the magnetic core 2 and molded support 15 may comprise four or more such positioning cavities 40 and positioning posts 26. Figure 4 is a view in cross section of the electric current transducer module 1 along line C-C of figure 3. The conductive grounding member 38 in the form of a fixing pin 52 is crimped onto the magnetic core 2 so that electrical contact with the magnetic core 2 is established. The magnetic core 2 consists of highly magnetically permeable sheet material 22. The fixing pin 52 extends through the complementary positioning cavity 40, the positioning post 26, the base 16 and the molded support 15 of the magnetic core mounting support 6 and through the circuit board 17 (compare figure 10). The fixing pin 52 grounds the magnetic core 2 by force-fit insertion through a plated through-hole in the circuit board 17 and/or solder connection to a metalized track on the circuit board.

The grounding and fixing mechanism 12 may advantageously comprise three or more fixing pins 52 whereby only one, or more or all fixing pins 52 can provide an electrical grounding connection.

Figure 5 is a view in cross section of the electric current transducer module 1 along line A - A of figure 3 and figure 6 is a view in cross section of the electric current transducer module 1 along line B - B of figure 3. The magnetic field detector 4 is visible including contact terminals 48 which are connected to the circuit board 17. The fixing pin 52 may be assembled and fixed to the molded support 15 and positioning post 26 during an injection molding process or may be driven into preformed holes of the molded support 15 in a force-fit stitching process

The positioning posts 26 of the molded support 15 are arranged on both sides of the air gap 20 and engage with the complementary positioning portions 40, 40'.

Figure 9 shows the magnetic circuit unit 3 from another perspective with ends 62 of the fixing and/or grounding pins 38, 52 extending below a lower face of the base 16 for connection to the circuit board. The circuit board connection ends 62 are intended to be inserted in holes formed into the circuit board 17. It can be seen in figure 9, that the molded base 15 of the magnetic circuit unit 3 spans across the width of the air gap 20 thus forming a bridge that stabilizes the portions of magnetic circuit either side of the air gap.

Figure 10 is a detailed view of the fixing connection between the magnetic core 2 and the magnetic core mounting support 6. The positioning post 26 has, prior to assembly, a slightly greater diameter than the complementary positioning cavity 40, thus engaging in the complementary positioning cavity 40 in a force fit connection.

The positioning post 26 may have a cylindrical shape or a non-cylindrical shape configured to force-fit in the cavity of the magnetic core, for instance a polygonal or star shape or similar. The post 26 may also have a slightly conical or tapered shape, with a diameter/size getting smaller towards a free end of the post 26. The height of the positioning post 26, as measured from the base 16, may in a variant, be slightly lower than the thickness of the magnetic core 2, thus ensuring that the crimped over fixing/grounding pin 38, 52 contacts the edge of the cavity 40 for an excellent mechanical and/or electrical connection between the magnetic core 2 and the fixing/grounding pin 38, 52. Positioning posts 26 may however have different heights within the scope of the present invention.

In an embodiment of a manufacturing process, the support 6 is mounted on the circuit board 8, then the magnetic field detector 4 is mounted on the circuit board and this assembly is soldered (e.g. by wave soldering) to connect the magnetic field detector and the circuit board connection ends 62 of the pins 38, 52 of the mounting support 6 to the circuit board, as well as other components to the circuit board, and then the magnetic core is mounted on the mounting support 6 and the pins 38, 52 are crimped to rigidly fix the core to the support. In a variant, the magnetic core 2 and/or the magnetic field detector 4 may be pre-assembled to the magnetic core mounting support 6 which is then mounted to the circuit board 8.

## Claims

1. An electric current transducer module comprising a magnetic circuit comprising a magnetic core (2) and an air gap (20), the magnetic core having a central passage (18) configured to receive a primary conductor (14) carrying a primary current to be measured through the central passage, a signal processing circuit (8) including a circuit board (17) and electrical terminals (32) for connection to external circuitry, and a magnetic field detector (4) arranged at least partially in the air gap (20) of the magnetic circuit , wherein the transducer further comprises a magnetic core mounting support (6) comprising a molded support (15) and a grounding and fixing mechanism (12) configured to hold and rigidly fix the magnetic core (2) to the molded support to form a magnetic circuit unit (3), said magnetic circuit unit (3) configured to be fixedly assembled to the printed circuit board.

2. An electric current transducer module according to the preceding claim, wherein the central passage (18) of the magnetic core (2) comprises an oval shape and the molded support (15) comprises a primary conductor passage (29) substantially congruent with the central passage (18).

3. An electric current transducer module according to any of the preceding claims, wherein the molded support (15) comprises a base (16) and at least one positioning post (26) protruding from the base, said positioning post (26) engaging in a complementary positioning cavity (40) formed in the magnetic core (2) configured for positioning the magnetic core (2) on the magnetic core mounting support (6).

4. An electric current transducer module according to either of the two directly preceding claims, wherein the molded support (15) comprises a plurality of positioning posts (26) and that the magnetic core (2) comprises a corresponding plurality of complementary positioning cavities (40), whereby at least two positioning posts (26) and two complementary positioning cavities (40) are arranged on opposite sides of the air gap (20).

5. An electric current transducer module according to the any of the three direct preceding claims, wherein the positioning posts (26) and the complementary positioning cavities (40) engage in a force-fit manner.

6. An electric current transducer module according to any of the preceding claims, wherein the molded support (15) comprises a magnetic field sensor guide member (28) configured to position the magnetic field detector (4) within the air gap (20).

7. An electric current transducer module according to any of the preceding claims, wherein the molded support (15) is made as a single part of injected plastic.

8. An electric current transducer module according to any of the preceding claims, wherein the grounding and fixing mechanism (12) comprises at least one fixing pin (52) fixed rigidly to the molded support and configured to be mechanically fixed at one end to the magnetic core and at another end to the circuit board.

9. An electric current transducer module according to the preceding claim, wherein at least one of said at least one fixing pin also forms a conductive grounding member (38) electrically connecting the magnetic core to an electrical ground contact of the signal processing circuit.

10. An electric current transducer module according to either of the two directly preceding claims wherein there are three or more fixing pins (52).

11. An electric current transducer module according to any of the three directly preceding claims wherein the fixing pins are crimped over the magnetic core.

12. An electric current transducer module according to any of the four directly preceding claims wherein the fixing pins extend through positioning posts as defined in any of claims 4-6.

13. An electric current transducer module according to any of the five directly preceding claims wherein the fixing pins are mounted to the molded support (15) by a force-fit insertion through through-holes in the support or by overmolding of the support.

14. An electric current transducer module according to any of the six directly preceding claims wherein the fixing pins comprise ends (62) for mechanical and/or solder connection to the circuit board.
